# EUROPEAN PATENT SPECIFICATION

(11) **EP 0 376 718 B1**
(45) Date of publication and mention of the grant of the patent: **18.10.1995**
(21) Application number: 89313643.2
(22) Date of filing: 28.12.1989
(51) Int. Cl.: H03K 3/356, H03K 17/30, H03K 19/003, H03B 19/00

(54) **A semiconductor device**
Halbleitereinrichtung
Dispositif à semi-conducteurs

(30) Priority: 28.12.1988 JP 334347/88
(43) Date of publication of application: 04.07.1990
(73) Proprietor: MITSUBISHI DENKI KABUSHIKI KAISHA, Tokyo (JP)
(72) Inventor: Maemura, Kousei c/o Mitsubishi Denki K.K., Mizuhara 4-chome Itami-shi Hyogo-ken (JP); Shimura, Teruyuki c/o Mitsubishi Denki K.K., Mizuhara 4-chome Itami-shi Hyogo-ken (JP); Seki, Hiroaki c/o Mitsubishi Denki K.K., Mizuhara 4-chome Itami-shi Hyogo-ken (JP)
(74) Representative: Beresford, Keith Denis Lewis

(56) References cited:
- US-A- 4 717 836
- US-A- 4 725 813
- US-A- 4 791 318
- IEEE JOURNAL OF SOLID-STATE CIRCUITS, vol. SC-19, no 5, October 1984, pages 710-715, New York, US; S. Shimizu et al.: "A 1 GHz 50 mW GaAs dual modulus divider IC"

## Description

### FIELD OF THE INVENTION

The present invention relates to a semiconductor device, and more particularly to a frequency divider circuit which is produced using a semi-insulating substrate.

### BACKGROUND OF THE INVENTION

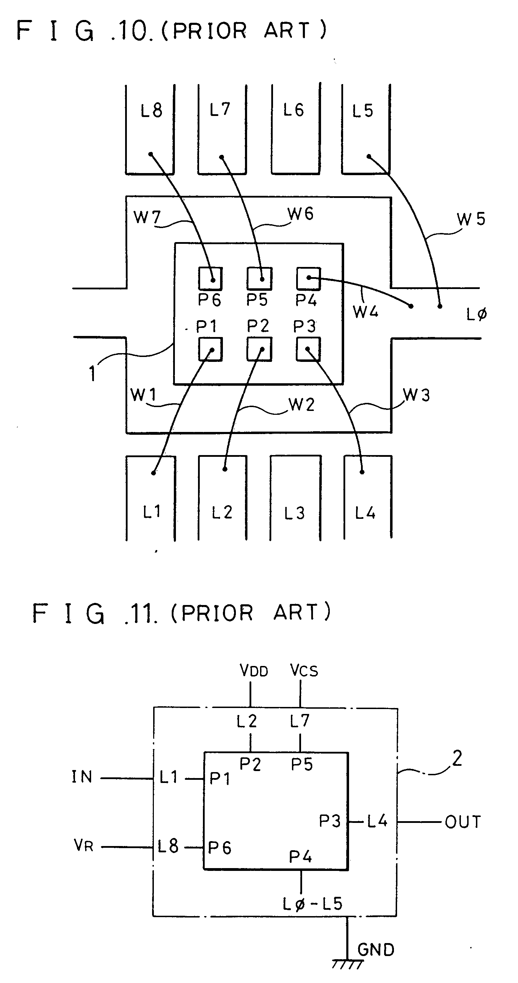

Figure 10 shows a wiring arrangement in a case where a conventional frequency divider circuit which is produced on a semi-insulating substrate such as GaAs substrate is sealed in a flat package. Figure 11 shows a circuit diagram thereof.

In the frequency divider circuit of figure 10, there are provided an input terminal P1 for inputting a signal to be frequency divided, a power supply (VDD) terminal P2, a frequency divider output terminal P3, a ground (GND) terminal P4, a current control terminal P5, and a reference voltage input terminal P6. There are further provided package leads L1 to L8 and a frame Lφ on which an IC pellet 1 is mounted, and bonding wires W1 to W7 are provided for connecting the terminals and the leads with each other. Among these wires, wires W4 and W5 connect the ground terminal P4 and the lead L5 via the frame Lφ.

Reference numeral 1 of figure 10 designates an IC chip, and reference numeral 2 represented by dotted line in figure 11 designates inside of package. In figure 11, there are provided a power supply voltage terminal V_{DD}, a current control terminal V_{CS}, an input terminal IN for a signal to be frequency divided, an input reference voltage terminal V_{R}, a ground terminal GND, and an output terminal OUT.

As shown in figures 10 and 11, the ground terminal GND is connected to the frame Lφ of package so as to stabilize the substrate voltage and such grounding of the substrate rear surface electrode stabilizes the circuit operation.

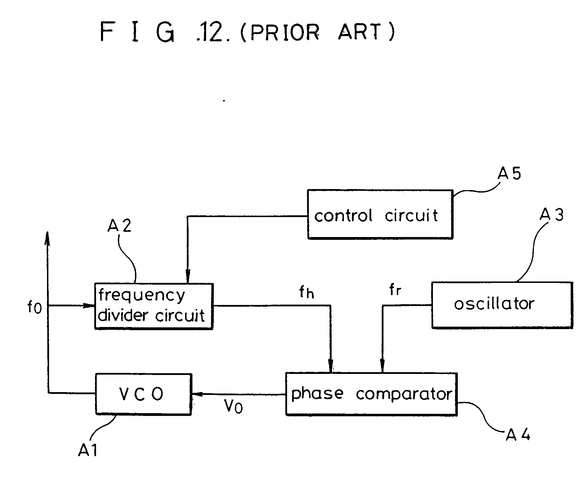

A phase locked loop (hereinafter referred (to as "PLL") frequency synthesizer for automobile telephone using this frequency divider circuit is shown in figure 12 as an example.

In figure 12, a voltage controlled oscillator (hereinafter referred to as "VCO") A1, a frequency divider circuit A2, a reference frequency oscillator A3, a phase comparator A4, and a control circuit A5 of the frequency divider circuit A2 are provided. In the figure, f₀ represents an oscillation frequency of the VCO A1, which is an output of the PLL frequency synthesizer, fₕ represents an output of the frequency divider circuit A2, fᵣ represents a reference frequency, and V₀ represents an output voltage of the phase comparator A4. In this construction, supposed that the frequency division rate of the frequency divider A2 is n, the fₕ is as follows.${\text{f}}_{\text{h}} \text{= f₀ / n}$

When the frequency fₕ is higher than the frequency fᵣ, the output voltage V₀ of the phase comparator A4 is lowered, and when the V₀ is thus lowered, that is, the input voltage of the VCO A1 is lowered, the f₀ is lowered and the following relation is established:${\text{f}}_{\text{h}} {\text{= f}}_{\text{r}}$
Then, this circuit is stabilized and the output frequency f₀ holds a constant value. Accordingly, from the formula (1), the output frequency of the PLL synthesizer, that is, f₀ is represeted by:${\text{f₀ = n · f}}_{\text{h}}$

Herein, the frequency division rate n of the frequency divider circuit A2 is variable dependent on the signal supplied from the control circuit A5, and accordingly, the output frequency f₀ can be made also variable.

Furthermore, in order to lower the current of the PLL frequency synthesizer, it is conceived to halt the operation of the frequency divider circuit when the circuit is not required for operation of synthesizer, and the way of constructing a frequency divider circuit in such case is reported in Patent Application No. Sho 63-294214.

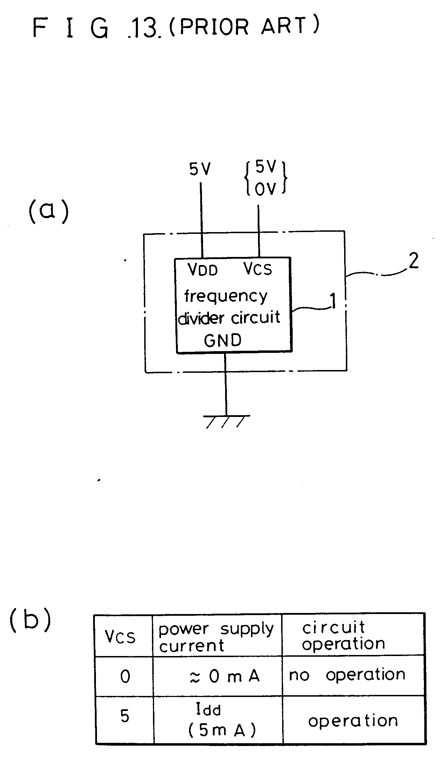

Figure 13(a) shows a frequency divider circuit having such a halting mode as one block. The V_{CS} terminal in figure 11 is a current switching terminal for this halting mode, and the frequency divider circuit 1 conducts a circuit operation in accordance with the applied voltage as shown in figure 13(b).

In such a system, circuits such as a control circuit or a phase comparator which have not to operate at high frequency are constituted by CMOS ICs comprising Si, and the power supply voltage V_{DD} thereof is usually 5 V single power supply. Accordingly, even in a frequency divider circuit which requires an operation at high frequency, the 5 V single power supply is also used. That is, V_{DD} is 5 V and GND is 0 V in figure 11.

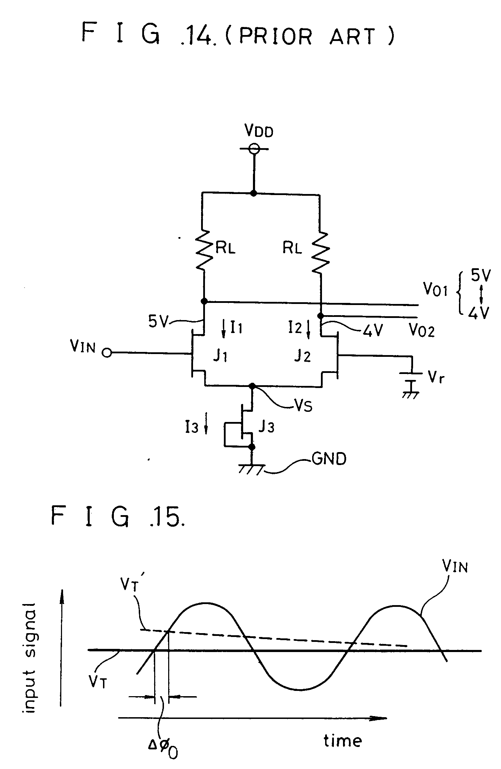

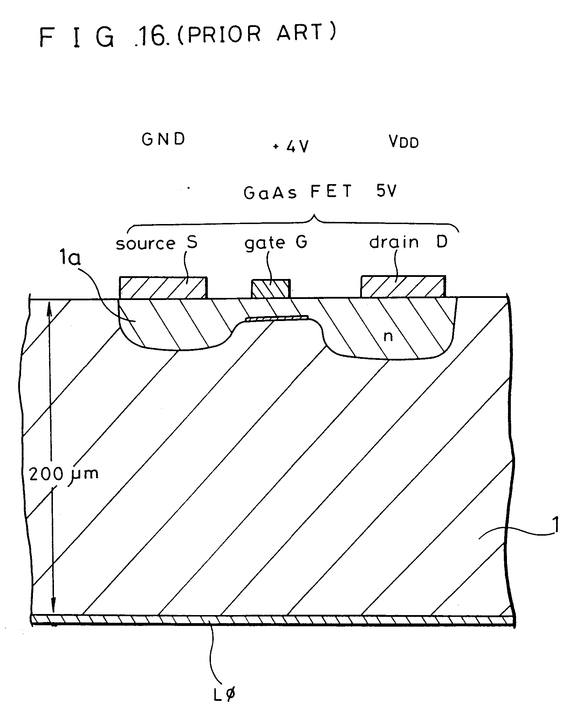

This means that the semi-insulating substrate may occasionally be set at 0 V and circuit elements such as FET or implantation resistor may operate at a voltage close to 4 V as shown in figure 14. When the active layer of implantation resistor or FET should have a voltage higher than the substrate, the characteristics of FET or resistance value of implantation resistor are found to vary in the operation at frequency of 0 to 5 KHz. The cause thereof is thought to be that an electron- hole trapping mechanism (not shown) arises between the semi-insulating substrate 1 and the active layer 1a as shown in figure 16, and thereby generating and forfeiting electrons and holes, changing the voltage applied to the active layer, and finally modulating the thickness of the active layer, as described in greater detail later.

If the characteristics of each FET should vary or the value of each resistor oscillate in such a frequency divider circuit, the output signal is phase-modulated and when such divider is used in a PLL frequency synthesizer, variations arise in the phase, thereby causing malfunction such as due to noise.

The manner of such malfunction will be described with reference to Figure 14. Figure 14 shows an example of a logic gate constituting a frequency divider circuit and this is a source coupled type logic gate. A GaAs SCFL structure of this type and the use of such a logic gate in a frequency divider circuit is described in IEEE Journal of Solid State Circuits vol. SC-19, no. 5, October 1984 pages 710-715, New York, USA, S. Shimizu et al. "A 1 GHz 50mw GaAs Dual Modulus Divider IC".

In Figure 14, there are provided field effect transistors (FET) J₁ to J₃, and J₁ and J₂ function as switching FETs and J₃ functions as a constant current source. There is also provided load resistors R_{L}, and Vr represents a reference voltage generator Vr. Reference character V_{DD} represents a power supply voltage and GND represents a ground voltage. Reference characters I₁ to I₃ designate currents flowing through the FETs J₁ to J₃, and reference character V_{S} represents source voltage of FETs J₁ and J₂, V_{IN} represents an input voltage, and V₀₁ and V₀₂ represent output voltages which are in relations inverted to each other.

When the threshold voltage of this logic gate V_{T} is made an input voltage in a state where the output signals V₀₁ and V₀₂ are made equal to each other, the gains of J₁ and J₂ are made K, the threshold voltage is made Vₜₕ, and the characteristics of the FETs J₁ and J₂ are made equal to each other, the currents I₁ and I₂ of the FETs J₁ and J₂ become as in the following:${\text{I₁ = K (V}}_{\text{IN}} {\text{- V}}_{\text{S}} {\text{- V}}_{\text{th}} \text{)²}$${\text{I₂ = K (V}}_{\text{r}} {\text{- V}}_{\text{S}} {\text{- V}}_{\text{th}} \text{)²}$

Therefore, when the input voltage V_{IN} is V_{T},$\text{I₁ = I₂,}$
and from the formulae (4) and (5),${\text{V}}_{\text{T}} {\text{= V}}_{\text{r}} \text{.}$

Now, if it is supposed that the voltage applied to the active layer is changed by the influences of the substrate voltage and the gain K varies by ΔK, the active layer of the FET J₂ is modulated and the threshold voltage Vₜₕ varies by ΔVₜₕ, the currents I₁ and I₂ become${\text{I₁ = K (V}}_{\text{IN}} {\text{- V}}_{\text{S}} {\text{′ - V}}_{\text{th}} \text{)²}$

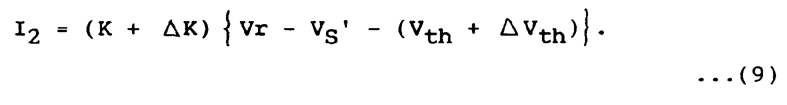

When V_{IN} = V_{T}′, the threshold voltage of the circuit V_{T}′ then becomes as in the following:$\text{I₃ = I₁ + I₂}$

Further, from the formula (6),$\text{I₁ = I₂ =} \frac{\text{I₃}}{\text{2}} \text{,}$
and from the formula (8),${\text{K (V}}_{\text{T}} {\text{′ - V}}_{\text{S}} {\text{′ - V}}_{\text{th}} \text{)² =} \frac{\text{I₃}}{\text{2}} {\text{∴ V}}_{\text{T}} \text{′ =} \sqrt{\frac{\text{I₃}}{\text{2 K}}} {\text{+ V}}_{\text{S}} {\text{′ + V}}_{\text{th}} \text{.}$

Furthermore, from the formulae (11) and (9),${\text{V}}_{\text{S}} \text{′ = -} \sqrt{\frac{\text{I₃}}{\text{2 (K + ΔK)}}} {\text{+ V}}_{\text{r}} {\text{- (V}}_{\text{th}} {\text{+ ΔV}}_{\text{th}} \text{),}$
and from the formula (12),${\text{V}}_{\text{T}} \text{′ =} \sqrt{\frac{\text{I₃}}{\text{2}}} \text{(} \frac{\text{1}}{\text{√K}} \text{-} \frac{\text{1}}{\sqrt{\text{K + ΔK}}} {\text{) + V}}_{\text{r}} {\text{- ΔV}}_{\text{th}} \text{.}$
Thus, the variation quantity ΔV_{T} of the V_{T} becomes,${\text{ΔV}}_{\text{T}} {\text{= V}}_{\text{T}} {\text{′ - V}}_{\text{r}} \text{=} \sqrt{\frac{\text{I₃}}{\text{2}}} \text{(} \frac{\text{1}}{\text{√K}} \text{-} \frac{\text{1}}{\sqrt{\text{K + ΔK}}} {\text{) - ΔV}}_{\text{th}} \text{.}$

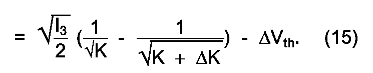

The threshold voltage V_{T} thus varies.

The phase modulation due to the variation in the threshold value will be described with reference to figure 15. In figure 15, V_{IN} designates an input signal, V_{T} and V_{T}′ designate threshold values of the circuit, and the Δφ₀ designates phase deviation due to the change in the threshold value.

As shown in figure 15, by that the threshold value V_{T} changes to V_{T}′, the phase information unfavourably varies by Δφ₀.

Thus, when a phase modulation of Δφ₀ arises in the output signal in the frequency divider circuit, supposed that the frequency division rate of the frequency divider circuit is n, the totalized phase error Δφ in the PLL frequency synthesizer becomes,$\text{Δφ = n · Δφ₀.}$

Such phase modulation arises in the frequency divider circuit when the frequency divider circuit is operated at an ambient temperature of above 60 °C, and the degree of modulation against the output signal is also low to be below - 60 dB, and this phase modulation has resulted in a problem in the conventional devices.

As described above, in the conventional frequency divider circuit produced on a semiconductor substrate, since 0 V is applied to the substrate even when the frequency divider circuit is operated at power supply voltage of 5 V, an oscillation arises between the internal element and substrate due to a so called back gate effect, and thereby resulting in a phase modulation in the output of the frequency divider circuit. This appears especially eminently in a semi-insulating substrate. This especially results in a problem in constituting a high speed PLL frequency synthesizer which is operable at GHz band.

The "back gate" effect though known to occur in MOSFET semiconductor devices has the first time been recognised as occurring in FET semi-insulator substrate IC circuits as disclosed herein.

In addressing the problems of the back gate effect in MOS type semiconductor substrate IC circuit devices it is known to set the back gates (i.e. the wells of each of the MOS transistors, which wells are insulated from the substrate) at the same potential as the source of each transistor i.e. the highest potential in the case of P channel MOS transistors, or at the lowest potential in the case of N channel MOS transistors. Such a remedy is applied in MOS type circuit devices described in US Patent US 4,725,813. In the circuits described therein the source electrode and the back gate region of each individual MOS transistor are kept at the same potential through an amplifier having a gain of about "1". Notably the back gate wells are conventional conductive semiconductor material and different source of voltages, highest and lowest potentials are required for P channel and N channel MOS transistors respectively.

The present invention is intended as a solution to the problems occurring in semi-insulating substrate semiconductor devices as described above, particularly semiconductor integrated circuit devices of the type which constitute a frequency divider and comprise a circuit element including two or more field effect transistors which are produced on a semi-insulating substrate.

In accordance with the present invention such a semiconductor device is characterised in that:
means are provided connecting the semi-insulating substrate to a voltage source such that the voltage of the semi-insulating substrate beneath each field effect transistor is substantially the same, the voltage being higher than the lowest one among the path applied voltages which are supplied to the frequency divider circuit.

The voltage of the semi-insulating substrate may, for example, be set at a voltage of a current control terminal for controlling the ON/OFF operation of the frequency divider circuit. The voltage may be set at the highest voltage among the path supply voltages, and may be supplied either from the rear or from the front surface of the substrate. Via interconnections may be made to the rear surface of the substrate or a buried conductive layer may be provided in the substrate.

Since the semi-insulating substrate is at a voltage which is higher than the lowest voltage amongst those of the power supply voltages, the electric field between each field effect transistor and the substrate is low and this prevents modulation of the FET characteristics and phase modulation of the output signal of the frequency divider circuit.

In the following drawings:
Figure 1 is a diagram showing an arrangement of a package including a frequency divider circuit according to a first embodiment of the present invention;
Figure 2 is a circuit diagram thereof;
Figures 3 and 4 are diagrams showing a third embodiment of the present invention;
Figures 5 and 6 are diagrams showing a second embodiment of the present invention;
Figures 7, 8 and 9 are diagrams showing a fourth, a fifth, and a sixth embodiment of the present invention, respectively;
Figure 10 is a diagram showing an arrangement of package of a frequency divider circuit according to the prior art;
Figure 11 is a circuit diagram of Figure 10;
Figure 12 is a diagram showing a PLL frequency synthesizer constituted by using a frequency divider circuit;
Figure 13 is a diagram showing a frequency divider circuit having a halting mode, wherein Figure 13(a) shows a schematic block diagram and Figure 13(b) shows an operation table;
Figure 14 is a circuit diagram of a logic gate constituting a frequency divider circuit;
Figure 15 is an operation timechart for explaining that a phase error arises caused by the frequency divider circuit; and
Figure 16 is a cross-sectional view showing a field effect transistor constituting a frequency divider circuit.

Embodiments of the present invention will be described in detail with reference to the drawings. The following description is given by way of example only.

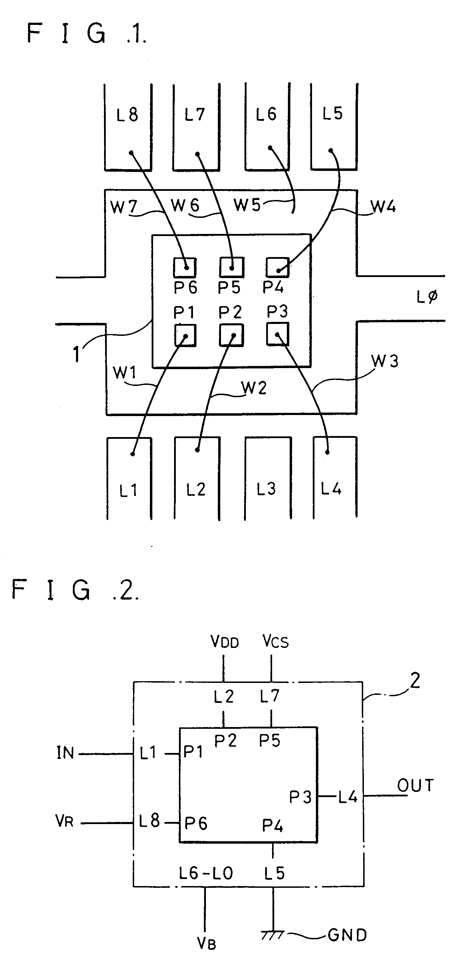

Figure 1 shows a semiconductor device according to a first embodiment of the present invention. This Figure shows a manner of arrangement in a case where a frequency divider circuit is sealed in a package. Figure 2 shows a circuit diagram thereof. In Figures 1 and 2, reference numeral 1 designates a semi-insulating substrate chip in which a frequency divider circuit is produced and reference numeral 2 designates the inside of package. There are provided an input terminal for inputting a signal to be frequency divided P1, a power supply terminal P2, a frequency divider output terminal P3, a ground terminal P4, a current control terminal P5, and a reference voltage input terminal P6. There are also provided leads of package L1 to L8, and a chip 1 is mounted on a frame Lφ . Bonding wires W1 to W7 are provided for connecting respective terminals and leads with each other. Amongst them, the wire W5 connects the frame L and the lead L6. Further, IN in figure 2 represents an input signal to be frequency divided, V_{R} a reference voltage, V_{DD} a power supply voltage, V_{CS} a current control signal, OUT an output signal, GND a ground voltage, and V_{B} a substrate voltage power supply.

In this embodiment, the voltage of the semi-insulating substrate in which a frequency divider circuit is produced is made a higher voltage than the lowest one amongst the power supply voltages supplied to the frequency divider circuit by the substrate voltage power supply V_{B}, and the supply of this substrate voltage is conducted by that a voltage independent on V_{DD} and GND is given from the outside to the frame on which the chip is mounted. Therefore, when the voltage of the substrate power supply V_{B} is made a fairly high voltage which is close to the power supply voltage, the substrate voltage is made fairly higher than that of the FET and the active layer of implantation resistance in the circuit, and an oscillation due to modulation of thickness of the active layer does not arise.

Herein, the reason why an oscillation due to the modulation of active layer arises when the substrate voltage is lower than the voltage of the channel as described in the prior art is considered to be as follows.

That is, when the substrate voltage is low and the voltage of the channel is high, a mechanism of trapping impurities is constituted in the substrate, and electrons from both of channel and substrate are captured thereby. When this mechanism is filled up with electrons, electrons are emitted and by repeating this capturing and emission, a voltage difference between the substrate and the channel varies and the extension of the depletion layer changes and the thickness of the active layer varies. However, when the substrate voltage is raised as in the present invention, the electric field between the substrate and the channel is weakened and the influences of the trapping mechanism are weakened, thereby removing the above-described oscillations. Thus, the output signal of the frequency divider circuit will not be phase-modulated and an accurate frequency division output signal is obtained.

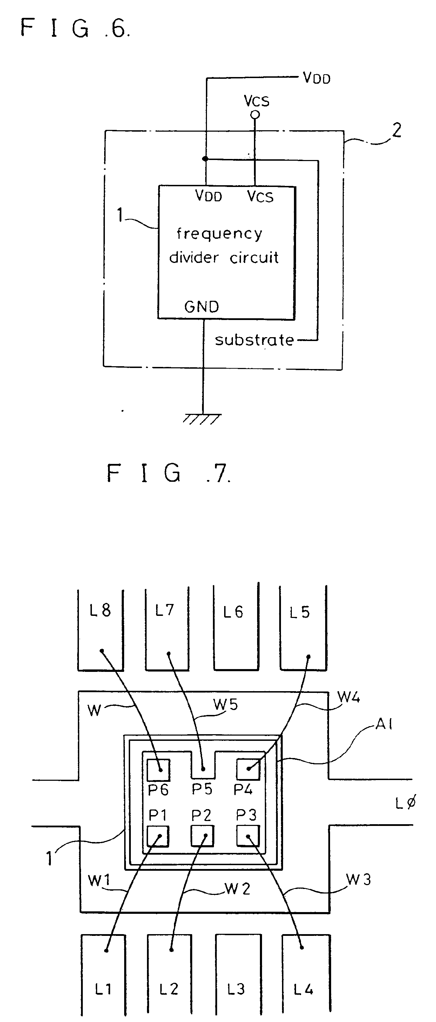

Figures 5 and 6 show a second embodiment of the present invention. In this second embodiment, the substrate voltage power supply V_{B} is made a power supply voltage V_{DD}. As a circuit connection, this power supply voltage V_{DD} is connected to the frame Lφ by a wire W.

In this second embodiment, because the substrate voltage V_{B} is set at V_{DD}, the oscillation due to modulation of thickness of active layer can be prevented and an accurate frequency division output is obtained as described in the first embodiment. Furthermore, since no other power supply is required for the substrate voltage V_{B}, this simplifies the circuit construction.

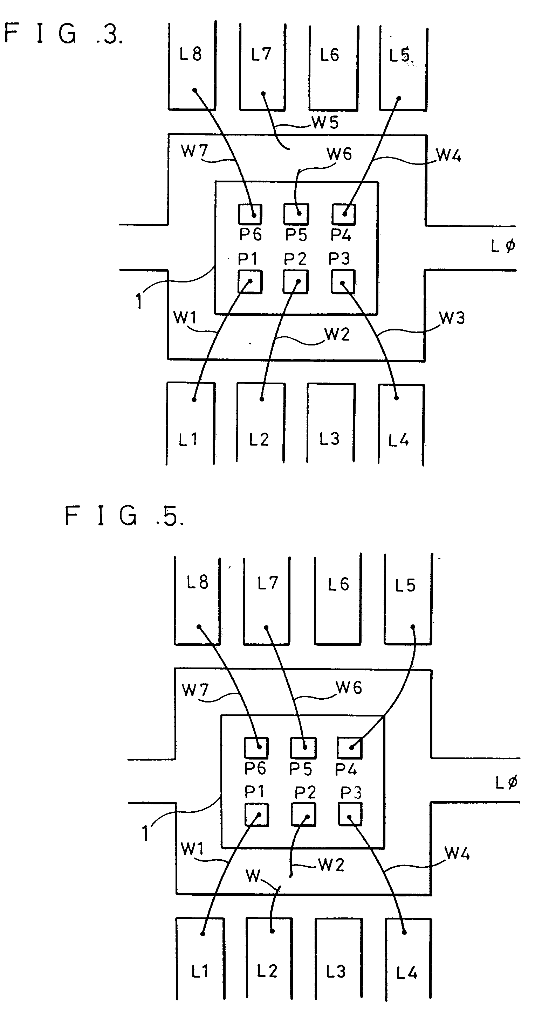

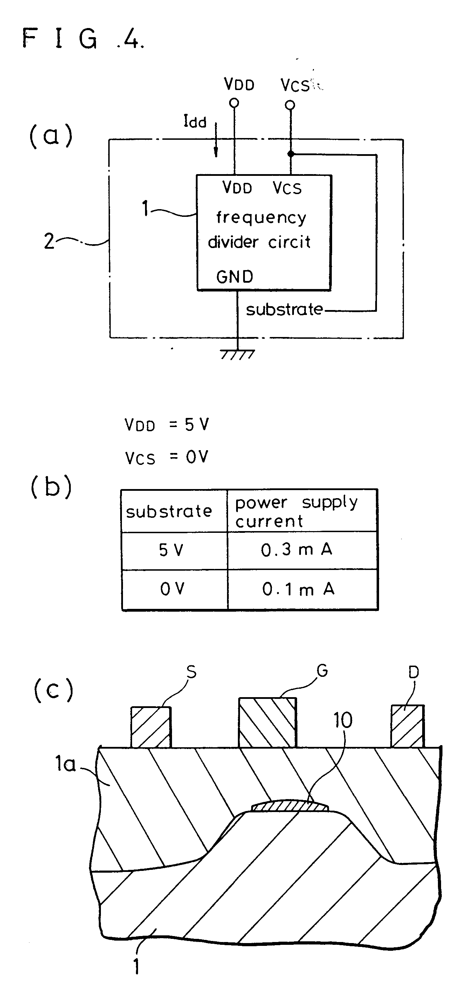

Figures 3 and 4 show a third embodiment of the present invention. In this third embodiment, the substrate voltage V_{B} is set at a voltage of a current control terminal V_{CS} for turning ON or OFF the operation of the frequency divider circuit, and as a circuit connection, a current control terminal V_{CS} is connected to the frame Lφ by the wire W5.

In this third embodiment, because the substrate voltage V_{B} is set at V_{CS}, the substrate voltage is made high to be close to V_{DD} in the operation of the frequency divider circuit and is made lower to be close to ground at the halting of the frequency divider circuit. Therefore,during operation the oscillations due to modulation of thickness of the active layer can be prevented, thereby obtaining an accurate frequency division output.

Furthermore, at the halting of the frequency divider circuit, it is quite natural that the circuit current flowing through the frequency divider circuit is reduced, and in addition thereto, by that the substrate voltage is made ground level, the FET and the active layer 1a of implantation resistor are made thin by the depletion layer extending from the interface with the substrate 1. Thus, such as leak current of circuit becomes difficult to flow, and the power supply current of frequency divider circuit can be reduced to a great extent.

In the above-described first, second, and third embodiments, as a method of giving a voltage to the substrate, respective power supply terminals are connected to the frame of package by wire bonding, and the voltages are given to the substrate from the chip rear surface. However, this may be conducted by other methods.

Figure 7 shows a fourth embodiment of the present invention. In this embodiment, an Al electrode pattern of V_{CS} electrode is produced in a contour configuration at the upper surface of semi-insulating substrate 1, and whereby the V_{CS} voltage is given to the substrate from the upper surface of substrate.

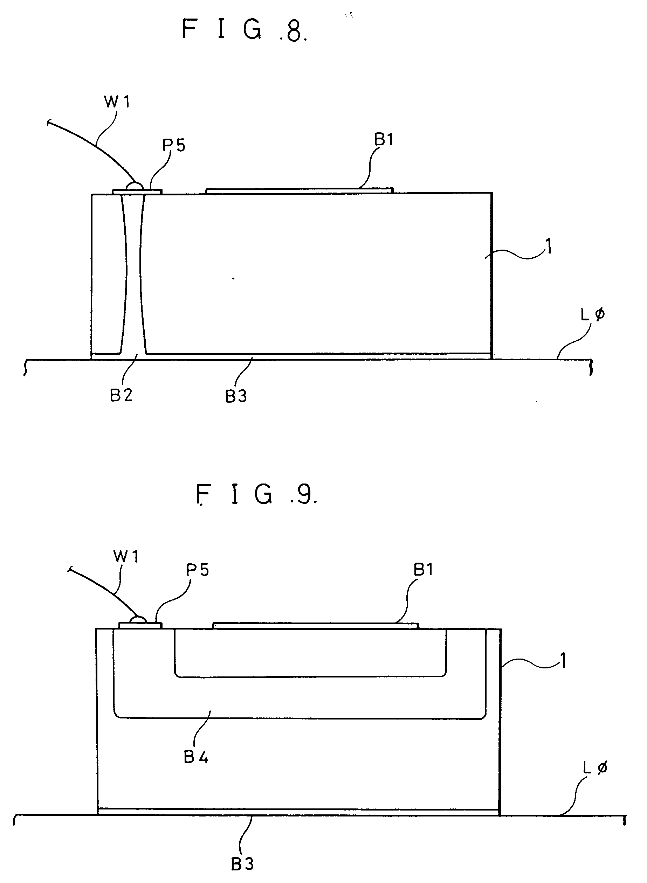

Figure 8 shows a fifth embodiment of the present invention. In this fifth embodiment, a via-hole aperture is provided penetrating from the front surface of substrate to the rear surface so as to enable to give the V_{CS} voltage to the substrate from the rear surface B3.

In more detail, in the device of figure 8, there are provided a bonding wire W1, a circuit pattern B1, and a via-hole aperture B2 which penetrates the substrate from the front surface to the rear surface. This via-hole aperture B2 is produced by conducting dry etching from the front surface of substrate to the rear surface thereof. Reference character B3 designates a rear surface electrode.

Figure 9 shows a sixth embodiment of the present invention. In this sixth embodiment, a conductivity layer is provided in the semi-insulating substrate, and a voltage is applied to this conductivity layer from the substrate front surface of substrate.

In more detail, in the device of figure 9, a conductivity layer B4 is provided in the substrate 1, and the V_{CS} voltage is given to this conductivity layer B4 from the terminal P5. In case where the V_{CS} voltage is given by the conductivity layer B4 to the substrate 1 on which a circuit pattern B1 is produced, the similar effects as described above are obtained.

In the above-illustrated embodiments of figures 7, 8, and 9, the V_{CS} voltage is given to the substrate. However, other power supply voltage which enables to make the substrate voltage high may be applied to the substrate with the same effects as described above.

As is evident from the foregoing description, according to the present invention, a semi-insulating substrate in which a frequency divider circuit is produced is made of higher voltage than that of the active layer of the circuit element. Therefore, an oscillation of circuit element is gone and no phase modulation arises in the output signal of frequency divider circuit. Accordingly, an accurate output signal is obtained.

## Claims

1. A semiconductor device constituting a frequency divider circuit (A1-A5), comprising circuit elements including two or more field effect transistors (J1-J3) which are produced on a semi-insulating substrate (1), characterised in that:-
means (L6,W5; L2,W; L7,W5; L7,W5; W1, P5, B2, B3; W1, P5, B4) are provided for connecting the semi-insulating substrate (1) to a voltage source (V_{B}, V_{DD}, V_{CS}) such that the voltage (V_{B}) of the semi-insulating substrate (1) beneath each field effect transistor (J1-J3) is substantially the same, the voltage (V_{B}) being higher than the lowest one among the power supply voltages (V_{DD}, V_{CS}) which are supplied to said frequency divider circuit (A1-A5).

2. A semiconductor device as defined in claim 1, wherein the voltage (V_{B}) of said semi-insulating substrate (1) is set at a voltage (V_{CS}) of a current control terminal (P5) for controlling ON/OFF of the operation of said frequency divider circuit (A1-A5).

3. A semiconductor device as defined in claim 1, wherein said voltage (V_{B}) of said semi-insulating substrate (1) is set at the highest voltage (V_{DD}, V_{CS}) among the power supply voltages (V_{DD}, V_{CS}) which are supplied to said frequency divider circuit (A1-A5).

4. A semiconductor device as defined in claim 1, wherein the supply of said voltage (V_{B}) to said semi-insulating substrate (1) is conducted from the rear surface of a portion where said frequency divider circuit (A1-A5) is produced through a mounting portion (Lφ) of package (2) to said semi-insulating substrate (1).

5. A semiconductor device as defined in claim 1, wherein the supply of said voltage (V_{B}) to said semi-insulating substrate (1) is conducted from the side where said frequency divider circuit (A1-A5) is produced, through a voltage supply terminal (P5).

6. A semiconductor device as defined in claim 1, wherein the supply of said voltage (V_{B}) to said semi-insulating substrate (1) is conducted from the rear surface (B3) through a via-hole aperture (B2), which is produced penetrating from the side where said frequency divider circuit (1) is produced to said rear surface (B3).

7. A semiconductor device as defined in claim 1, wherein the supply of said voltage (V_{B}) to said semi-insulating substrate (1) is conducted through a conductivity layer (B4) produced inside said semi-insulating substrate (1).

## Patentansprüche

1. Halbleitervorrichtung, die eine Frequenzteilerschaltung (A1-A5) bildet, die Schaltungselemente aufweist, die zwei oder mehr Feldeffekttransistoren (J1-J3) beinhalten, welche auf einem halbisolierenden Substrat (1) hergestellt sind, *dadurch gekennzeichnet, daß*
Einrichtungen (L6,W5; L2,W; L7,W5; L7,W5; W1, P5, B2, B3; W1, P5, B4) so zum Anschließen des halbisolierenden Substrats (1) an eine Spannungsquelle (V_{B,},V_{DD}, V_{CS}) vorgesehen sind, daß die Spannung (V_{B}) des halbisolierenden Substrats (1) unterhalb jedes Feldeffekttransistors (J1-J3) im wesentlichen die Gleiche ist, wobei die Spannung (V_{B}) größer ist als die kleinste aus den Stromversorgungsspannungen (V_{DD}, V_{CS}), welche an die Frequenzteilerschaltung (A1-A5) angelegt werden.

2. Halbleitervorrichtung nach Anspruch 1, bei der die Spannung (V_{B}) des halbisolierenden Substrats (1) auf eine Spannung (V_{CS}) eines Stromsteueranschlusses (B5) zum Steuern des EIN/AUSSCHALTENS des Betriebs der Frequenzteilerschaltung (A1-A5) eingestellt ist.

3. Halbleitervorrichtung nach Anspruch 1, bei der die Spannung (V_{B}) des halbisolierenden Substrats (1) auf die höchste Spannung (V_{DD}, V_{CS}) aus den Stromversorgungsspannungen (V_{DD}, V_{CS}) eingestellt wird, welche an die Frequenzteilerschaltung (A1-A5) angelegt werden.

4. Halbleitervorrichtung nach Anspruch 1, bei der das Anlegen der Spannung (V_{B}) an das halbisolierende Substrat (1) von der rückseitigen Oberfläche eines Abschnitts, wo die Frequenzteilerschaltung (A1-A5) hergestellt ist, durch einen Befestigungsabschnitt (Lφ) eines Gehäuses (2) an das halbisolierende Substrat (1) durchgeführt wird.

5. Halbleitervorrichtung nach Anspruch 1, bei der das Anlegen der Spannung (V_{B}) an das halbisolierende Substrat (1) von der Seite, wo die Frequenzteilerschaltung (A1-A5) hergestellt ist, durch einen Spannungsversorgungsanschluß (P5) durchgeführt wird.

6. Halbleitervorrichtung nach Anspruch 1, bei der das Anlegen der Spannung (V_{B}) des halbisolierenden Substrats (1) von der rückseitigen Oberfläche (B3) durch eine Durchgangslochöffnung (B2) durchgeführt wird, welche so hergestellt ist, daß sie von der Seite, wo die Frequenzteilerschaltung (1) hergestellt ist, an die rückseitige Oberfläche (B3) vordringt.

7. Halbleitervorrichtung nach Anspruch 1, bei der das Anlegen der Spannung (V_{B}) an das halbisolierende Substrat (1) durch einen leitende Schicht (B4), die innerhalb des halbisolierenden Substrats (1) hergestellt ist, durchgeführt wird.

## Revendications

1. Dispositif à semi-conducteurs constituant un circuit diviseur de fréquence (A1-A5), comprenant des éléments de circuit comprenant deux ou plus transistors à effet de champ (J1-J3) qui sont produits sur un substrat semi-isolant (1), caractérisé en ce que : -
des moyens (L6,W5; L2,W; L7,W5; L7,W5; W1, P5, B2, B3; W1, P5, B4) sont prévus pour relier le substrat semi-isolant (1) à une source de tension (V_{B}, V_{DD}, V_{CS}) de sorte que la tension (V_{B}) du substrat semi-isolant (1) en dessous de chaque transistor à effet de champ (J1-J3) est sensiblement la même, la tension (V_{B}) étant supérieure à la plus faible parmi les tensions d'alimentation (V_{DD}, V_{CS}) qui sont appliquées au circuit diviseur de fréquence (A1-A5).

2. Dispositif à semi-conducteurs comme défini en revendication 1, dans lequel la tension (V_{B}) du substrat semi-isolant précité (1) est établie à une tension (V_{CS}) d'une borne de commande de courant (P5) pour commander la MISE EN SERVICE/HORS SERVICE du fonctionnement du circuit diviseur de fréquence précité (A1-A5).

3. Dispositif à semi-conducteurs comme défini en revendication 1, dans lequel la tension précitée (V_{B}) du substrat semi-isolant (1) est établie à la tension la plus élevée (V_{DD}, V_{CS}) parmi les tensions d'alimentation (V_{DD}, V_{CS}) qui sont appliquées au circuit diviseur de fréquence précité (A1-A5).

4. Dispositif à semi-conducteurs comme défini en revendication 1, dans lequel l'application de la tension précitée (V_{B}) au substrat semi-isolant précité (1) est conduite à partir de la surface arrière d'une portion où le circuit diviseur de fréquence précité (A1-A5) est produit à travers une portion de montage (Lφ) du boîtier (2) au substrat semi-isolant (1).

5. Dispositif à semi-conducteurs comme défini en revendication 1, dans lequel l'application de la tension précitée (V_{B}) au substrat semi-isolant précité (1) est conduite à partir du côté où le circuit diviseur de fréquence précité (A1-A5) est produit, à travers une borne d'alimentation en tension (P5).

6. Dispositif à semi-conducteurs comme défini en revendication 1, dans lequel l'application de la tension précitée (V_{B}) au substrat semi-isolant (1) est conduite à partir de la surface arrière (B3) à travers une ouverture traversante (B2), qui est produite pénétrant à partir du côté où le circuit diviseur de fréquence précité (1) est produit vers la surface arrière (B3).

7. Dispositif à semi-conducteurs comme défini en revendication 1, dans lequel l'application de la tension précitée (V_{B}) au substrat semi-isolant précité (1) est conduite à travers une couche de conductivité (B4) produite à l'intérieur du substrat semi-isolant (1).
